(19) Europäisches Patentamt
European Patent Office
Office européen des brevets

(11) **EP 0 925 386 B1**

(12) **EUROPÄISCHE PATENTSCHRIFT**

(45) Veröffentlichungstag und Bekanntmachung des Hinweises auf die Patenterteilung:
**05.03.2003 Patentblatt 2003/10**

(51) Int Cl.⁷: **C23C 28/04**, C23C 30/00, C23C 14/06

(21) Anmeldenummer: **97936553.3**

(22) Anmeldetag: **03.09.1997**

(86) Internationale Anmeldenummer:
**PCT/CH97/00321**

(87) Internationale Veröffentlichungsnummer:
**WO 98/010120 (12.03.1998 Gazette 1998/10)**

(54) **VERSCHLEISSSCHUTZ-BESCHICHTETES WERKSTÜCK**

WORKPIECE WITH WEAR-PROTECTIVE COATING

PIECE AVEC COUCHE DE PROTECTION CONTRE L'USURE

(84) Benannte Vertragsstaaten:
**AT BE CH DE DK ES FR GB LI**

(30) Priorität: **03.09.1996 JP 25238496**
**03.09.1996 JP 25238596**

(43) Veröffentlichungstag der Anmeldung:
**30.06.1999 Patentblatt 1999/26**

(73) Patentinhaber: **Unaxis Balzers Aktiengesellschaft**
**9496 Balzers (LI)**

(72) Erfinder: **BRAENDLE, Hans**
**CH-7320 Sargans (CH)**

(74) Vertreter: **Troesch Scheidegger Werner AG**
**Patentanwälte**
**Postfach**
**8032 Zürich (CH)**

(56) Entgegenhaltungen:
EP-A- 0 197 185       EP-A- 0 470 644
EP-A- 0 592 986       EP-A- 0 685 572
EP-A- 0 701 982       EP-A- 0 709 483
EP-A- 0 709 484       EP-A- 0 736 615
EP-A- 0 753 603       JP-A- 8 209 335
US-A- 5 350 599

• PATENT ABSTRACTS OF JAPAN vol. 018, no. 203 (M-1590), 11.April 1994 & JP 06 008010 A (MITSUBISHI MATERIALS CORP), 18.Januar 1994,
• PATENT ABSTRACTS OF JAPAN vol. 018, no. 203 (M-1590), 11.April 1994 & JP 06 008009 A (MITSUBISHI MATERIALS CORP), 18.Januar 1994,
• PATENT ABSTRACTS OF JAPAN vol. 014, no. 531 (C-0780), 21.November 1990 & JP 02 221364 A (TOSHIBA CERAMICS CO LTD), 4.September 1990,
• PATENT ABSTRACTS OF JAPAN vol. 018, no. 392 (C-1228), 22.Juli 1994 & JP 06 108254 A (MITSUBISHI MATERIALS CORP), 19.April 1994,
• PATENT ABSTRACTS OF JAPAN vol. 018, no. 145 (C-1178), 10.März 1994 & JP 05 320870 A (NISSIN ELECTRIC CO LTD), 7.Dezember 1993,
• PATENT ABSTRACTS OF JAPAN vol. 018, no. 296 (C-1209), 6.Juni 1994 & JP 06 057429 A (MITSUBISHI MATERIALS CORP), 1.März 1994,
• P.W. ATKINS: "Pysikalische Chemie" 2. Auflage, Verlag Chemie, Weinheim (DE). 2. Auflage, 1996, Seiten 683 - 685

**Beschreibung**

Die vorliegende Erfindung betrifft ein Verfahren nach dem Oberbefriff von Anspruch 1.

Zur Erstellung eines Verschleissschutzsystems an Wertstücken, insbesondere an Werkzeugen, dabei vor allem an Stahl- und Hartmetallwerkzeugen, ist es bekannt, Hartstoffschichten, beispielsweise Schichten aus TiN bzw. TiCN auf das zu schützende Werkstück aufzubringen. Unter Hartmetallen werden Sintercarbide (Cemented Carbide) verstanden. Dabei ist es möglich, die Verschleiss-, insbesondere die Oxidationsfestigkeit, der erwähnten Schichten durch Zusatz von Aluminium zu erhöhen. Dies ist beispielsweise aus der JP-OS Nr. 4-53642/92 oder 5-67705/93 bekannt. Im weiteren ist es bekannt, die Eigenschaften einer Verschleissschutzschicht durch Bildung einer übergitterstruktur. (Superlattice) zu verbessern, wozu beispielsweise auf die JP-OS Nr. 7-97679/95 verwiesen sei.

Die Anforderungen an den Verschleissschutz nehmen zu. So werden beispielsweise beim Zerspanen an Verschleissschutz-beschichtete Werkzeuge immer höhere Anforderungen bezüglich der erzielbaren Schneidgeschwindigkeit gestellt, um dadurch zu höheren Durchsätzen bzw. zu einer höheren Effizienz zu gelangen.

Bei der Formbearbeitung wurde üblicherweise meist ein weicher Stahl vor der Wärmebehandlung bearbeitet. Heute wird die Formbearbeitung erst nach der Wärmebehandlung durchgeführt, d.h. nach der Härtung des Stahls.

Die oxidationsbeständigkeit der oben erwähnten Beschichtungen mit Aluminium-Zusatz ist in vielen Fallen, wie beispielsweise beim Hochgeschwindigkeits-Zerspanen, nicht zufriedenstellend, beispielsweise für spanendes Bearbeiten gehärteter Materialien. Dies, obwohl, wie erwähnt, Aluminium-Zusatz die diesbezüglichen Eigenschaften, wie beispielsweise von TiN von TiCN-Schichten, verbessert.

Die erwähnten Verschleissschutz-Schichten werden üblicherweise durch Vakuumbeschichtungsverfahren aufgebracht, wie beispielsweise durch Ionenplatieren (Ionplating), oder ggf. auch durch CVD-Verfahren.

Beim Aufbringen dieser Schichten, wie beispielsweise durch Ionenplatieren, nehmen die in der Beschichtung verbleibenden Druckrestspannungen proportional zur Dicke der aufgebrachten Schicht zu. Entsprechend der Zunahme der Druckrestspannungen nimmt die Adhäsion bzw. die auch unter dem Aspekt der Scherbelastung zu betrachtende Haftung zwischen Schicht und Werkstückkörper, insbesondere aus Stahl oder Hartmetall, ab, so dass Schichtdicken von höchstens 5 µm eingesetzt werden können. Weil gerade beim Ionenplatieren relativ ausgeprägte Druckrestspannungen verbleiben, ist es auch bekannt, dass durch dieses Verfahren Verschleissschutz-beschichtete Werkstücke gegenüber mittels chemischen Dampfabscheidungs-Verfahren (CVD) beschichteten Werkstücken unterlegen sind, indem bei Einsatz des letzterwähnten Verfahrens aufgrund der erwähnten Druckrestspannungen Schichtdicken von 5 bis 15 µm einsetzbar sind.

Wird die Härte der Schicht durch Bildung einer Übergitterstruktur (Superlattice) erhöht, so wird damit wohl die Verschleissfestigkeit erhöht, gleichzeitig aber weist eine solche, harte Schicht ein hohes Young-sches Modulus auf und sehr hohe Druckrestspannungen, womit die Dicke einer solchen Schicht doch auf lediglich 3 bis 5 µm begrenzt werden muss. Das Auftreten der erwähnten hohen Druckrestspannungen bei Beschichtung mit Übergitterstruktur führt im weiteren auch zu Haftungsproblemen zwischen Schicht und Werkstückkörper.

Aus der EP-0685572 ist es bekannt mittels CVD eine TiCN Schicht abzulegen, bei der sich die Vorzugsorientierung gegen eine aussen anliegende $AL_2O_3$ Schicht ändert.

Aus der JP 08-209335 ist es bekannt an Schichten die mit Vorzugsorientierung (200) oder (111) aufwachsen, eine gewünschte Vorzugsorientierung mittels Substratbiasspannung einzustellen. Dabei wird an einer der betrachteten Schichten der Quotient (200)/ (111) zu mindestens 1,5 eingestellt.

Es ist Aufgabe der vorliegenden Erfindung, ausgehend von der EP-0685572, die Druckrestspannungen weiter zu vermindern.

Damit soll das Verfahren nässig hergestellt Verschleissschutz-beschichtete Werkstück mit einem Verschleissschutz-Schichtsystem hergestellt werden, welches unter gleichzeitiger Erhöhung der Verschleisstestigkeit. und damit Verringerung der Haftungsprobleme, wesentlich dicker ausgebildet sein kann als bis anhin. Dies wird durch das Verfahren gelost, welches sich nach dem Kennzeichen von Anspruch 1 auszeichnet.

Es wurde demnach erkannt, dass durch Vorsehen eines Verschleissschutz-Schichtsystems mit den mindestens zwei sich folgenden Schichten, je mit der unterschiedlichen kristallographischen Vorzugsorientierung wie in Anspruch 1 Angegeben die gestellte Aufgabe gelöst wird. Damit wird eine erhöhte Schichtdicke realisierbar, ohne dass die Druckrestspannungen entsprechend zunähmen.

Bevorzugte Ausführungsformen der Erfindung werden nun anschliessend beschrieben.

Eine entsprechende Prozessfürung des Beschichtungsprozesses mit Verschleissschutz-geeigneten Materialien ergibt jeweils eine kristallographische Vorzugsorientierung im Kristallwachstum, dabei insbesondere bei reaktiven PVD-Verfahren wie bei kathodischem Lichtbogenverdampfen und Sputtern. Eine beispielsweise durch Lichtbogenverdampfen hergestellte Schicht weist im allgemeinen eine Vorzugsorientierung im Kristallwachstum auf, so dass die Schicht mit einer säulenförmigen Kristallstruktur gebildet wird. Ein säulenförmiges Kristallpartikel ist in der Regel als Einkristall ausgebildet, der in einer bestimmten Richtung gewachsen ist und sehr wenige Defektstellen aufweist. Die Kristalle reihen sich durchlaufend aneinander und bilden so eine Schicht, wodurch die Druckrestspannungen proportional zur Dicke der Schicht, wie erwähnt, zunehmen. Der Erfindung liegt nun die Erkenntnis zugrunde, dass, wenn zwei sich folgende Schichten, mit unterschiedlichen, kristallographischen Vorzugsorientierungen abgelegt werden, an der Grenzfläche zwischen den Schichten eine Vielzahl von Gitterdefektstellen eingeführt wird. Werden z.B. und bevorzugterweise eine zur (111)-Ebene vorzugsorientierte Schicht aus TiN und eine zur (200)-Ebene vorzugsorientierte Schicht aus TiAlN oder eine zur (111)-Ebene vorzugsorientierte Schicht aus TiCN und eine aus TiAlCN bestehende, zur (200)-Ebene vorzugsorientierte Schicht paarweise als Zwei- oder Mehrschichtsystem aneinander geschichtet, womit die Schichtgrenzflächen diskontinuierlich ausgebildet werden und ein epitaxiales Wachstum verhindert wird, so wird damit an den Schichtgrenzflächen die erwähnte Vielzahl von Gitterdefektstellen eingeführt. Derartige Schichtmaterial paarungen sind:

TiN / TiCN
TiN / TiAlCN
TiCN / TiCN
TiCN / TiAlN
TiCN / TiAlCN
TiAlN / TiAlN
TiAlN / TiAlCN
TiAlCN / TiAlCN.

Diese Gitterdefekte werden während des weiteren Schichtwachstums derart ausgerichtet, dass die Druckrestspannung über dem gesamten Schichtsystem vermindert wird. Es ergibt sich praktisch eine Druckrestspannungs-Ausgleichszone zwischen den erwähnten Schichten. Damit wird die Bildung einer gesamthaft dicken Schicht bzw. eines Schichtsystems mit einer geringen Druckrestspannung möglich.

Es weist eine zur (200)-Ebene vorzugsorientiert TiAlN-Schicht mit einer Dicke von 0,5 µm eine Druckrestspannung von 1,2 GPa auf, während die Druckrestspannung in einer TiAlN-Schicht mit der Dicke von 10 µm und gleich ausgerichtet bereits 8 GPa überschreitet und ihre Haftung entsprechend schlechter ist. Wird aber eine 0,5 µm dicke, zur (200)-Ebene vorzugsorientierte TiAlN-Schicht und eine 0,5 µm, zur (111)-Ebene vorzugsorientierte TiN-Schicht abwechselnd zur Bildung eines Verschleissschutz-Schichtsystems aufgebracht, und zwar mehrschichtig, beispielsweise bis zu einer Dicke von 10 µm, so ergibt sich überraschenderweise eine verbleibende Druckrestspannung von höchstens 2 GPa.

Wie ersichtlich, wird in einer bevorzugten Ausführungsform die unterschiedliche Vorzugsorientierung durch den Einsatz unterschiedlicher Schichtmaterialien, bei gleichbleibender oder unterschiedlicher Führung eines Vakuumbeschichtungsprozesses, realisiert.

Als PVD-Beschichtungsverfahren werden reaktive bevorzugt insbesondere kathodisches Lichtbogenverdampfen und Sputtern.

Bei den Werkstücken, vorzugsweise aus einem Stahl oder einem Hartmetall, handelt es sich vorzugsweise um Werkzeuge, dabei insbesondere um Umform- oder Stanzwerkzeuge, insbesondere bevorzugt um Wendeschneidplatten, Schaftwerkzeuge, insbesondere Bohrer oder Fräser, weiter Verzalmungswerkzeuge, Sägeblätter.

Mit dem erfindungsgemäss hergestellten Verschleissschutz-beschichteten Werkstück, wie insbesondere dem eben beschriebenen, mit 10 µm und mehr dicken, durch Mehrfachpaarung hergestellten Verschleissschutz-System wird auch verhindert, beispielsweise beim zerspanenenden Einsatz eines als Werkzeug ausgebildeten, erfindungsgemässen werkstückes, dass die während dem Zerspanen an der Schichtoberfläche erzeugten Risse sich in den Grenzflächen zwischen den Schichten ausbreiten. Die am Rissansatz auftretende Spannungskonzentration wird nämlich durch die Vielzahl von Gitterdefekten an der erwähnten Grenzfläche vermindert, welche Grenzfläche mithin einen ausgeprägten Widerstand gegen die Weiterübertragung von Rissen bildet. Wenn die Risse trotzdem grösser werden sollten, so werden sie nicht auf den Grundkörper übertragen, sondern verlaufen nur entlang den Grenzflächen zwischen den erwähnten Schichten, so dass Scharten an Schneidekanten weitestgehend verhindert werden.

Wenn sich Risse entlang den Grenzflächen zwischen den Schichten ungehindert ausbreiten könnten, so würde dies die Gefahr in sich bergen, dass sich einzelne Schichten des Verschleissschutz-Schichtsystems ablösen, wodurch auch die Verschleissfestigkeit verschlechtert würde. Es wurde aber gefunden, dass sich die Risse eben nicht ungehindert entlang den Grenzflächen zwischen den Schichten ausbreiten können. Grundsätzlich dürfte dies daran liegen, dass aufgrund der erfindungsgemässen unterschiedlichen Vorzugsorientierung, und damit der hohen Störstellendichte im Schichtübergangsbereich, eine Rissausbreitung in diesem Übergangsbereich massgeblich unterbunden wird.

Als Resultat ergibt sich, dass ein erfindungsgemäss hergestellten Verschleissschutzbeschichtetes Werkstück wegen der daran vorgesehenen Schichtsystemdicke eine hohe Verschleissfestigkeit aufweist, wobei sich Risse kaum durch das Verschleissschutz-Schichtsystem fortbilden, d.h. das Verschleissschutz-Schichtsystem weist eine hohe Zähigkeit auf. Damit wird mit dem erfindungsgemässen Werkstück, und verglichen mit Werkstücken mit verschleissschutz-Systemen ohne Vorzugsorientierungswechsel zwischen den Schichten, nicht nur eine erhöhte Schichtsystemdicke einsetzbar, sondern es ergeben sich auch bei dünnen Schichtsystemen, gegenüber den vorbekannten, beispielsweise gegenüber Werkzeugen mit gleicher Dicke einer einheitlichen Schicht, wesentlich verlängerte Standzeiten.

Definition

Es bedeutet I(XXX) die Intensität der (XXX)-Ebene, gemessen mittels Röntgenbeugung nach der θ-2θ-Methode.

Der Wert des Quotienten I(200)/I(111) der Schichten, aus TiAlN, wird zu mindestens 1,3 gewählt, weil mit höherer (111)-Vorzugsorientierung an dieser Schicht eine höhere Druckrestspannung resultiert, was unerwünscht ist. Wenn diese Schicht aber (200)-vorzugsorientiert ist, so wird die Druckrestspannung der Schicht klein gehalten. Deshalb benötigt diese Schicht eine (200)-Vorzugsorientierung, womit der erwähnte Quotientenwert bevorzugt zu mindestens 1,3 gewählt wird. Dies gilt insbesondere für Schichten aus einem der erwähnten Al enthaltenden Materialien.

Zur Einführung der Gitterdefekte an der Grenzfläche zwischen der einen Schicht und der anderen, sollte letztere umgekehrt vorzugsorientiert sein. Mithin sollte im oberwähnten Beispiel die andere Schicht aus TiN eine (111)-Vorzugsorientierung aufweisen, womit an dieser Schicht bevorzugterweise ein Quotientenwert I(200)/I(111) höchstens 0,7 betragen soll.

Wenn die Gesamtdicke des Schichtsystems 1 μm unterschreitet, so übt ein solches Schichtsystem eine nur vernachlässigbare Verschleissschutz-Wirkung aus. Wenn anderseits die Gesamtdicke des Schichtsystems 15 μm überschreitet, so können sich Probleme betreffs Haftung am Stahlgrundkörper ergeben, womit bevorzugterweise das Verschleissschutz-Schichtsystem mindestens 1 μm dick ist und vorzugsweise höchstens 15 μm.

Beispiel 1

Es wurden Hartmetall-Wendeschneidplatten entsprechend JIS P40 und im Markt erhältliche HSS-Schaftfräser durch kathodisches Lichtbogenverdampfen mittels Ti-Target und TiAl-Target (Ti/Al = 50/50) beschichtet und erfindungsgemässe Schichtsysteme gemäss Tabelle 1 gebildet. In den Vergleichsbeispielen wurden jeweils TiN- bzw. TiAlN-Schichten nach dem gleichen Verfahren, nämlich kathodisches Lichtbogenverdampfen, als Einschicht-Systeme aufgebracht.

Die beschichteten Hartmetall-Wendeschneidplatten wurden unter den unten wiedergegebenen Zerspanungsbedingungen Nr. 1 so lange getestet, bis der Verschleiss an der Freifläche 0,3 mm erreichte. Es wurde die Zerspanungslänge ermittelt als Standzeitkriterium.

Die beschichteten HSS-Schaftfräser wurden nach den ebenfalls unten angegebenen Zerspanungsbedingungen Nr. 2 getestet, bis der Verschleiss an der Freifläche 0,2 mm erreichte. Es wurde ebenfalls die Zerspanungslänge ermittelt als Standzeitkriterium. Die Ergebnisse sind aus Tabelle 1 ersichtlich.

Zerspanungsbedingungen Nr. 1:

Für Hartmetall-Wendeschneidplatte (SEE 42-TN)

- Zu zerspanendes Material: X 40 CrMoV51 (DIN 1.2344), DAC(HRC40)

- Schnittgeschwindigkeit: 100m/min

- Vorschub: 0,1 mm/Zahn

- Schnittiefe: 2 mm

- Trockenbearbeitung

Zerspanungsbedingungen Nr. 2:

Für HSS-Schaftfräser

- Zu zerspanendes Material: 40CrMoV51 (DIN 1.2344), DAC(HRC10)

- Schnittgeschwindigkeit: 50 m/min

- Vorschub 0,07 mm/Zahn

- axiale Schnittiefe: 18 mm

- radiale Schnittiefe: 6 mm

- trocken, Gleichlauf

Tabelle 1

| Probe Nr. | | Gesamtdicke der Schicht (µm) | Schichtanzahl | TiN I(200)/ I(111) | TiAlN I(200)/ I(111) | Werkzeugs-Lebensdauer (m) | |
|---|---|---|---|---|---|---|---|
| | | | | | | Hartmetall-Wendeschneideplatte | HSS-Schaftfräser |
| Erf. Beispiele | 1 | 8 | 16 | 0.5 | 1.5 | 5.7 | 48.8 |
| | 2 | 8 | 16 | 0.5 | 8.2 | 6.8 | 52.1 |
| | 3 | 8 | 16 | 0.1 | 1.5 | 8.9 | 51.3 |
| | 4 | 8 | 16 | 0.1 | 8.2 | 12.5 | 46.2 |
| | 5 | 13 | 26 | 0.5 | 8.2 | 22.8 | 88.5 |
| | 6 | 5 | 10 | 0.5 | 6.3 | 4.2 | 32.3 |
| | 7 | 3 | 8 | 0.5 | 6.3 | 1.7 | 22.5 |
| | 8 | 10 | 20 | 0.1 | 10.2 | 7.8 | 55.5 |
| | 9 | 10 | 20 | 0.1 | 15.1 | 8.9 | 57.8 |
| | 10 | 10 | 40 | 0.1 | 15.1 | 11.2 | 58.2 |
| Vergl. Beispiele | 11 | 3 | 1(TiN) | 0.5 | - | 0.8 | 8.3 |
| | 12 | 10 | 1(TiN) | 0.5 | - | 0.5 (Abplatzung) | 1.5 (ausgebrochen) |
| | 13 | 3 | 1(TiAl)N | - | 10.2 | 1.5 | 21.2 |
| | 14 | 10 | 1(TiAl)N | - | 10.2 | 0.5 | 10.2 (ausgebrochen) |

Wie aus obiger Tabelle 1 ersichtlich, wird beim erfindungsgemässen Verschleissschutz-beschichteten Stahlkörper in Form der erwähnten Werkzeuge mit einer Gesamtverschleissschutz-Schichtsystemdicke von weit mehr als 10 µm (erfindungsgemässes Beispiel 5) die Druckrestspannung beherrscht, so dass kein Abplatzen der Schicht entsteht und keine Schartenbildung an der Schneidkante auftritt, und dies während sehr langer Standzeiten, verglichen mit den Vergleichsbeispielen mit lediglich Einschicht-Verschleissschutz-Schichtsystemen.

In einer Weiterausbildung der Erfindung wurde zwischen den Schichten eine Übergangsschicht im Sinne eines Schichtüberganges von 5 nm bis 500 nm vorgesehen, in welcher beide Materialien der angrenzenden Schichten vorhanden sind, also bei den anliegenden Schichten aus TiN und TiAlN-Schichten diese beiden erwähnten Materialien. Dadurch wurde die Tendenz, dass sich Risse entlang der Schichtgrenzflächen ausbreiten, noch wirksamer bekämpft.

Wenn die Dicke der Übergangsschicht 5nm und kleiner ist, ist kein zusätzlicher Effekt gegen die entlang der Grenzfläche verlaufenden Risse erzielbar, und wenn sie 500nm überschreitet, neigt die Schicht zum epitaxialen Wachstum z.B. des Ti-Nitrids bzw. -Kohlenstoffnitrids und TiAl-Nitrids bzw. -Kohlenstoffnitrids, so dass der Wert $I(200)/I(111)$ nicht leicht steuerbar ist. Deshalb ist die Dicke der Übergangsschicht auf 5nm bis 500nm beschränkt.

In nachfolgender Tabelle 2 sind die bei dieser Weiterbildung erzielten Resultate im Vergleich mit Resultaten an Einschicht-Verschleissschutz-geschützten Werkzeugen dargestellt, wobei wiederum die im Beispiel 1 beschriebene Beschichtungstechnik und Zerspanungstestbedingungen eingesetzt wurden.

Die Übergangsschicht wurde durch gleichzeitiges kathodisches Lichtbogenverdampfen aus den entsprechenden Ti-Targets bzw. TiAl-Targets erstellt. Wie bereits im Ausführungsbeispiel 1, wurden die Schichten durch reaktives kathodisches Lichtbogenverdampfen in Stickstoff-enthaltender Reaktivgasatmosphäre erzeugt.

Tabelle 2:

| Probe Nr. | | Gesamtdicke der Schicht (μm) | Schichtanzahl | TiN I(200)/ I(111) | Dicke des Übergangs (nm) | TiAlN I(200)/ I (111) | Werkezugs-Lebensdauer Hartmetall-Wendeschneidplatte | (m) HSS-Schaftfräser |
|---|---|---|---|---|---|---|---|---|
| <u>Erf.</u> Beispiele | 1 | 8 | 16 | 0.5 | 50 | 1.5 | 6.6 | 55.2 |
| | 2 | 8 | 16 | 0.5 | 50 | 8.2 | 8.6 | 60.1 |
| | 3 | 8 | 16 | 0.1 | 50 | 1.5 | 9.8 | 58.2 |
| | 4 | 8 | 16 | 0.1 | 50 | 8.2 | 15.8 | 48.8 |
| | 5 | 13 | 26 | 0.5 | 100 | 8.2 | 23.1 | 90.2 |
| | 6 | 5 | 10 | 0.5 | 100 | 6.3 | 4.0 | 33.5 |
| | 7 | 3 | 8 | 0.5 | 100 | 6.3 | 2.5 | 25.2 |
| | 8 | 10 | 20 | 0.1 | 50 | 10.2 | 9.2 | 56.0 |
| | 9 | 10 | 20 | 0.1 | 50 | 15.1 | 12.5 | 55.0 |
| | 10 | 10 | 40 | 0.1 | 50 | 15.1 | 15.1 | 56.0 |
| | 11 | 8 | 16 | 0.5 | 45 | 5.5 | 6.5 | 55.0 |
| | 12 | 8 | 16 | 0.5 | 15 | 6.8 | 9.5 | 62.1 |
| | 13 | 8 | 16 | 0.5 | 100 | 12.5 | 15.1 | 75.1 |
| | 14 | 8 | 16 | 0.7 | 200 | 2.2 | 5.2 | 52.1 |
| | 15 | 8 | 16 | 0.7 | 400 | 1.3 | 4.3 | 42.1 |
| | 16 | 13 | 16 | 0.7 | 50 | 20.0 | 21.2 | 88.1 |

Tabelle 2:  (fortgesetzt)

| Probe Nr. | | Gesamtdicke der Schicht (µm) | Schichtanzahl | TiN I(200)/ I(111) | Dicke des Übergangs (nm) | TiAlN I(200)/ I (111) | Werkezugs-Lebensdauer Hartmetall-Wendeschneidplatte | (m) HSS-Schaftfräser |
|---|---|---|---|---|---|---|---|---|
| Vergl. Beispiele | 17 | 3 | 1(TiN) | 0.5 | - | - | 0.8 | 8.3 |
| | 18 | 10 | 1(TiN) | 0.5 | - | - | 0.5 (Abplatzung) | 1.5 (ausgebrochen) |
| | 19 | 3 | 1(TiAl)N | - | - | 10.2 | 1.5 | 21.2 |
| | 20 | 10 | 1(TiAl)N | - | - | 10.2 | 0.5 | 10.2 (ausgebrochen) |
| | 21 | 3 | 1(TiN) | 0.1 | - | - | 0.9 | 8.3 |
| | 22 | 8 | 1(TiN) | 0.1 | - | - | 0.6 (abgeplatzt) | abgeplatzt nach der Beschichtung |
| | 23 | 3 | 1(TiAl)N | - | - | 6.8 | 1.4 | 20.5 |
| | 24 | 8 | 1(TiAl)N | - | - | 6.8 | 0.2 (abgeplatzt) | 2.5 (abgeplatzt) |

Wie nun aus Tabelle 2 mit Übergangsssicht klar ersichtlich, wird durch Vorsehen dieser Übergangsschicht mit einer Dicke zwischen 5 und 500 nm, dabei bevorzugterweise zwischen 10 nm und 400 nm, eine eher noch bessere Standzeit erhalten.

Am erfindungemässen Werkstück kann mithin ein Verschleissschutz-Schichtsystem mit erhöhter Schichtdikke und Standzeit vorgesehen sein, vorzugsweise aufgebracht durch ein reaktives PVD-Verfahren, ggf. auch ein nicht-reaktives PVD-Verfahren, wobei sich als PVD-Verfahren insbesondere kathodisches Lichtbogenverdampfen und Sputtern, reaktiv oder nicht-reaktiv ausgeführt, besonders eignen. Wesentlich ist am erfindungsgemässen Werkstück bzw. dessen Hersteilverfahren die Realisation der unterschiedlichen Vorzugsorientierung an den zwei sich folgenden Schichten mit ggf. dazwischen eingebetteter Übergangsschicht. Es wird damit ein Verschleissschutz-beschichtetes Werkstück geschaffen, dessen Verschleissschutz-Schichtsystem eine hohe Zähigkeit aufweist, wobei die Gesamtverschleissschutz-Schichtsystem-Dicke ausgehend von dünnen Schichtsystemen bis hin zu dicken gewählt werden kann und dabei jedenfalls die Standzeit derartiger Werkstücke und insbesondere Werkzeuge, verglichen mit gleich dick Einschicht-Verschleissschutz-beschichteten, ganz wesentlich erhöht werden kann.

**Patentansprüche**

1.  Verfahren zur Herstellung Verschleissschutzbeschichteter Werkstücke mit einem Grundkörper und einem System von Hartstoffschichten, bei dem von zwei sich folgenden Schichten die eine Schicht mit Kristallen abgelegt wird, die überwiegend in der (111) Ebene aufwachsen, die zweite mit Kristallen abgelegt wird, die überwiegend in der (200) Ebene aufwachsen, **dadurch gekennzeichnet, dass** die erste Schicht aus TiN abgelegt wird mit einem Quotienten

$$Q = I(200)/I(111)$$

für welchen gilt

$$Q \leq 0,7$$

die zweite Schicht aus TiAlN mit

$$Q \geq 1,3$$

und dass das System von Hartstoffschichten aus den erwähnten Schichten mittels PVD abgelegt wird.

2.  Verfahren nach Anspruch 1 **dadurch gekennzeichnet, dass** die sich folgenden Schichten ineinander übergehend abgelegt werden und eine Übergangsschicht gebildet wird.

3.  Verfahren nach einem der Ansprüche 1 oder 2 **dadurch gekennzeichnet, dass** die Schichten mit einer Dicke von höchstens 2 μm abgelegt werden, vorzugsweise von höchstens 1 μm.

4.  Verfahren nach einem der Ansprüche 1 bis 3, **dadurch gekennzeichnet, dass** das System von Hartstoffschichten mit einer Gesamtdicke von mindestens 1 μm abgelegt wird und vorzugsweise von höchstens 15 μm.

5.  Verfahren nach Anspruch 2, **dadurch gekennzeichnet, dass** die Übergangsschicht mit einer Dicke zwischen 5 nm und 500 nm erzeugt wird, vorzugsweise zwischen 10 nm und 400 nm.

6.  Verfahren nach einem der Ansprüche 1 bis 5, **dadurch gekennzeichnet, dass** das System von Hartstoffschichten aus mehr als zwei der Schichten aufgebaut wird.

7.  Verfahren nach einem der Ansprüche 1 bis 6, **dadurch gekennzeichnet, dass** das System von Hartstoffschichten auf einem Grundkörper aus einem Stahl oder aus einem Hartmetall abgelegt wird.

8.  Verfahren nach einem der Ansprüche 1 bis 7 für die Herstellung von Umform- oder Stanzwerkzeugen, vorzugsweise von Wendeschneidplatten, Schaftwerkzeugen, dabei insbesondere von Bohrern oder Fräsern oder von Verzahnungswerkzeugen oder Sägeblättern.

**Claims**

1. Method for the production of workpieces with a wear-protective coating, with a base body and a system of hard material layers, in which of two successive layers the one layer is deposited with crystals which grow predominantly in the (111) plane, the second layer is deposited with crystals which grow predominantly in the (200) plane, **characterised in that** the first layer is deposited of TiN with a quotient

$$Q = I(200)/I(111)$$

for which

$$Q \leq 0.7$$

the second layer is deposited of TiAIN with

$$Q \geq 1.3$$

and that the system of hard material layers from the said layers is deposited by means of PVD.

2. Method according to claim 1, **characterised in that** the successive layers are laid gradually blending and a transitional layer is formed.

3. Method according to claim 1 or 2, **characterised in that** the layers are deposited with a thickness of maximum 2 μm, preferably maximum 1 μm.

4. Method according to any of claims 1 to 3, **characterised in that** the system of hard material layers is deposited with a total thickness of at least 1 μm and preferably maximum 15 μm.

5. Method according to claim 2, **characterised in that** the transitional layer is produced with a thickness between 5 nm and 500 nm, preferably between 10 nm and 400 nm.

6. Method according to any of claims 1 to 5, **characterised in that** the system of hard material layers is constructed from more than two of the layers.

7. Method according to any of claims 1 to 6, **characterised in that** the system of hard material layers is deposited on a base body of steel or a hard metal.

8. Method according to any of claims 1 to 7 for the production of moulding or punching tools, preferably indexable inserts, end milling tools, here in particular drills or milling cutters, or gear cutting tools or saw blades.

**Revendications**

1. Procédé pour fabriquer des pièces à revêtement anti-usure avec un corps de base et un système de couches en matière dure, selon lequel sur deux couches successives, l'une est déposée avec des cristaux qui croissent principalement dans le plan (111), et l'autre est déposée avec des cristaux qui croissent principalement dans le plan (200), **caractérisé en ce que** la première couche est déposée en TiN avec un quotient

$$Q = I(200)/I(111)$$

pour lequel

$$Q \leq 0,7$$

la seconde couche en TiAlN avec

$$Q \geq 1,3$$

et **en ce que** le système de couches en matière dure des deux couches mentionnées est déposé par dépôt physique en phase vapeur.

2.  Procédé selon la revendication 1, **caractérisé en ce que** les couches successives sont déposées avec interpénétration et une couche d'interpénétration est formée.

3.  Procédé selon la revendication 1 ou 2, **caractérisé en ce que** les couches sont déposées avec une épaisseur de 2 µm au maximum, de préférence de 1 µm au maximum.

4.  Procédé selon l'une des revendications 1 à 3, **caractérisé en ce que** le système de couches de matière dure est appliqué avec une épaisseur totale de 1 µm au minimum et de préférence de 15 µm au maximum.

5.  Procédé selon la revendication 2, **caractérisé en ce que** la couche d'interpénétration est produite avec une épaisseur située entre 5 nm et 500 nm, de préférence entre 10 nm et 400 nm.

6.  Procédé selon l'une des revendications 1 à 5, **caractérisé en ce que** le système de couches de matière dure est formé de plus de deux des couches.

7.  Procédé selon l'une des revendications 1 à 6, **caractérisé en ce que** le système de couches de matière dure est déposé sur un corps de base en acier ou en métal dur.

8.  Procédé selon l'une des revendications 1 à 7 pour fabriquer des outils de façonnage ou de découpage, de préférence des plaquettes réversibles, des outils à tige, et en particulier des forets ou des fraises ou des outils à tailler les engrenages ou des lames de scie.